# EUROPEAN PATENT SPECIFICATION

(11) **EP 3 276 657 B1**
(45) Date of publication and mention of the grant of the patent: **07.09.2022**
(21) Application number: 16181359.7
(22) Date of filing: 27.07.2016
(51) Int. Cl.: H01L 23/427, H01L 23/373, H01L 23/00, H05K 7/20

(54) **COOLER, POWER SEMICONDUCTOR MODULE ARRANGEMENT HAVING A COOLER, AND METHOD FOR PRODUCING THE SAME**
KÜHLER, LEISTUNGSHALBLEITERMODULANORDNUNG MIT KÜHLER UND VERFAHREN ZUR HERSTELLUNG DAVON
REFROIDISSEUR, AGENCEMENT D'UN MODULE SEMI-CONDUCTEUR DE PUISSANCE COMPORTANT UN REFROIDISSEUR ET PROCÉDÉ DE PRODUCTION DE CELUI-CI

(43) Date of publication of application: 31.01.2018
(73) Proprietor: Infineon Technologies AG, 85579 Neubiberg (DE)
(72) Inventor: UHLEMANN, Andre, 44229 Dortmund (DE); KOCH, Christoph, 33154 Salzkotten (DE); THOBEN, Markus, 59494 Soest (DE); SCHWARZ, Alexander, 59494 Soest (DE)
(74) Representative: Westphal, Mussgnug & Partner, Patentanwälte mbB

(56) References cited:
- WO-A1-2013/080611
- DE-A1-102010 003 533
- JP-A- S6 095 951
- JP-A- S6 095 952
- "Excerpt. PHENOMENES DE TRANSPORT. Deuxième Partie ED - ABLITZER D; COMBEAU H", 1 January 1996 (1996-01-01), PHENOMENES DE TRANSPORT. DEUXIÈME PARTIE, EEIGM, PAGE(S) 83 - 174, XP001525460, * page 83 - page 102 *
- JOSEPH R DAVIS ED - DAVIS ET AL: "Understanding the Corrosion Behavior of Aluminum", 1 January 1999 (1999-01-01), CORROSION OF ALUMINIUM AND ALUMINIUM AL, ASM INTERNATIONAL, MATERIALS PARK, OHIO; US, PAGE(S) 25 - 38, XP008182574, ISBN: 0-87170-629-6 * cf. text disclosed in conjunction with tables 1-6 and figure 4; figure 4; tables 1-6 *

## Description

### TECHNICAL FIELD

The instant disclosure relates to a cooler, a power semiconductor module arrangements having a cooler, to a method for producing a cooler, and to a method for producing a power semiconductor module arrangement having a cooler.

### BACKGROUND

Many technical fields like automotive applications employ power semiconductor modules. The high power densities required for today power semiconductor module applications require that the heat generated in the semiconductor chips of the power semiconductor module is dissipated to a cooler. Often, fluid coolers with a cavity for receiving a fluid coolant are used as such coolers excellently dissipate the heat emitted by the semiconductor chips of the power semiconductor module. Many conventional fluid coolers include a surface increasing structure like fins or pins disposed as close as possible to the semiconductor chips so that the thermal resistance between the semiconductor chips and the surface increasing structure is kept low. Producing such a fin or pin structure is expensive. There are conventional coolers in which the surface increasing structure is a bonding wire bonded to a thin ceramic substrate having a thin, double-sided metallized ceramic layer. However, the bonding wires tend to lift off from the substrate over the course of time resulting in a worsened cooling efficiency. Furthermore, thin metallised ceramics substrates show the tendency to crack when being subjected to the pressure of a fluid coolant.

Hence, there is a general need for a cooler having a good and long lasting cooling efficiency, and for a power semiconductor module arrangement that includes a cooler having good and long lasting cooling efficiency. Further, there is a need for a method of producing such a cooler and a power semiconductor module arrangement.

DE 10 2010 003533 A1 relates to a heat sink structure. A substrate is attached to a body of a heat sink such that a chamber for receiving a cooling fluid is formed therebetween. A wire structure which during operation immerses in the cooling fluid is wire bonded to the substrate. The wire structure may include Al, AlMg or Cu.

JP S60 95952 discloses Al-alloys having alloying constituents like, e.g., Si and Mg.

WO 2013/080611 A1 relates to a heat exchanger having a sealed container and a plurality of inner fins arranged therein. The sealed container is formed from a first aluminium alloy and the plurality of inner fins are formed from a second aluminium alloy. Several alloys having alloying constituents like, e.g., Si and Mg are investigated.

"PHENOMENES DE TRANSPORT", Deuxième Partie ED, EEIGM, ABLITZER D; COMBEAU H", 1995-1996 provides theoretical considerations regarding heat transport.

JOSEPH R DAVIS ET AL: "Understanding the Corrosion Behavior of Aluminum", 1 January 1999 (1999-01-01), CORROSION OF ALUMINIUM AND ALUMINIUM AL, ASM INTERNATIONAL, MATERIALS PARK, OHIO considers effects of principal alloying elements like Cu, Mg, Mn, Si, Zn on electrolytic solution potential of aluminum.

### SUMMARY

A first aspect relates to a cooler. The cooler has a cooler body, a cavity formed in the cooler body, and a bonding wire. The bonding wire is disposed inside the cavity and directly bonded to a first surface of the cooler body. The bonding wire includes at least 99.50 percent by weight aluminium (Al); at least 0.25 percent by weight silicon (Si); at least 0.05 percent by weight magnesium (Mg); and at least 0.05 percent by weight manganese (Mn).

A second aspect relates to a power semiconductor module arrangement with a cooler. The cooler has a cooler body, a cavity formed in the cooler body, and a bonding wire. The bonding wire is disposed inside the cavity and directly bonded to a first surface of the cooler body. The bonding wire includes at least 99.50 percent by weight aluminium (Al); at least 0.25 percent by weight silicon (Si); at least 0.05 percent by weight magnesium (Mg); and 0.05 to 1.50 percent by weight manganese (Mn). A semiconductor chip is attached to a contact surface of the cooler.

A third aspect relates to a method for producing a cooler. In that method, a bonding wire is directly bonded to a first surface of a first part or of a second part of the cooler body by ultrasonic wire bonding. The first part and the second part are joined so that a cavity is formed between the first part and the second part and that the bonding wire is disposed inside the cavity. The bonding wire includes at least 99.50 percent by weight aluminium (Al), at least 0.25 percent by weight silicon (Si), at least 0.05 percent by weight magnesium (Mg); and at least 0.05 percent by weight manganese (Mn).

A fourth aspect relates to a method for producing a power semiconductor module arrangement. In that method, a bonding wire is directly bonded to a first surface of a first part or of a second part of the cooler body by ultrasonic wire bonding. The first part and the second part are joined so that a cavity is formed between the first part and the second part and that the bonding wire is disposed inside the cavity. The bonding wire includes at least 99.50 percent by weight aluminium (Al), at least 0.25 percent by weight silicon (Si), at least 0.05 percent by weight magnesium (Mg); and at least 0.05 percent by weight manganese (Mn). A semiconductor chip is attached to the second part.

The cooler, the power semiconductor module arrangement and the method for producing the power semiconductor module arrangement may be better understood with reference to the following drawings and description. The features in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional side view illustrating the assembling of a power semiconductor module arrangement according to a first example.
Figure 2 is a cross-sectional side view illustrating the completed power semiconductor module arrangement according to the first example.
Figure 3 is a cross-sectional side view illustrating the assembling of a power semiconductor module arrangement according to a second example.
Figure 4 is a cross-sectional side view illustrating the completed power semiconductor module arrangement according to the second example.
Figure 5 is a cross-sectional side view illustrating the assembling of a power semiconductor module arrangement according to a third example.
Figure 6 is a cross-sectional side view illustrating the completed power semiconductor module arrangement according to the third example.
Figure 7 is a cross-sectional side view illustrating a bonding wire directly bonded to a surface of a cooler body.
Figure 8 is a cross-sectional side view illustrating a bonding wire directly bonded at at least two bonding locations to a surface of a cooler body.
Figure 9 is a cross-sectional side view illustrating a bonding wire directly bonded at at least two bonding locations to a surface of a cooler body having a coating.
Figure 10 is a top view illustrating a bonding wire according to Figures 8 and 9 wherein two bonding locations are disposed distant from one another in a first lateral direction.
Figure 11 is a top view illustrating a bonding wire according to Figures 8 and 9 wherein two bonding locations are disposed distant from one another in a second lateral direction.
Figure 12 is a bottom view illustrating a base plate of a power semiconductor module with a plurality of bonding wires bonded to the base plate according to a first example.
Figure 13 is a bottom view illustrating a base plate of a power semiconductor module with a plurality of bonding wires bonded to the base plate according to a second example.
Figure 14 is a bottom view illustrating a base plate of a power semiconductor module with a plurality of bonding wires bonded to the base plate according to a third example.
Figure 15 is a bottom view illustrating a base plate of a power semiconductor module with a plurality of bonding wires bonded to the base plate according to a fourth example.
Figure 16 is an isometric view illustrating a base plate of a power semiconductor module with a plurality of ribbon-like bonding wires bonded to the base plate.

### DETAILED DESCRIPTION

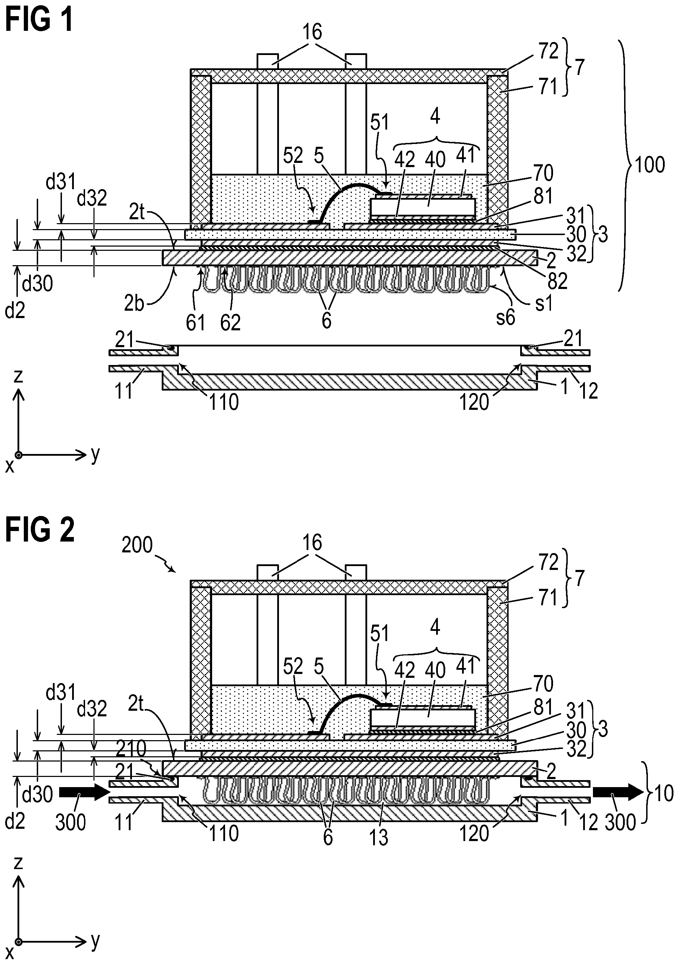

Figures 1 schematically illustrates an exemplary power semiconductor module arrangement during assembly 200, and Figure 2 illustrates the completed power semiconductor module arrangement 200. The coordinate system illustrated in an orthogonal coordinate system.

As can be seen from Figures 1 and 2, the power semiconductor module arrangement includes a power semiconductor module 100 having a base plate 2 and a semiconductor chip 4 disposed on the base plate. The base plate 2 serves as a carrier for the semiconductor chip 4, and as a heat spreader. A cooler 10 of the power semiconductor module arrangement 200 includes a first part 1 joined to a second part 2, a cavity 13 formed between the first part 1 and the second part 2, a bonding wire structure disposed inside the cavity 13 and including at least one bonding wire 6, an optional inlet 11 with an inlet opening 110 for supplying a cooling fluid 300, e.g. a liquid or a gas, to the cavity 13, and an optional outlet 12 with an outlet opening 120 for discharging the cooling fluid from the cavity 13. Optionally, the first part 1 may be tub-shaped. The base plate 2 of the power semiconductor module 100 is used as the second part 2 of the cooler 10. In the following, the terms "base plate 2" and "second part 2" are used synonymously. Each of the bonding wires 6 of the bonding wire structure is, at at least one bonding location 61, 62, directly bonded to at least one of the first part 1 and the second part 2 by ultrasonic wire bonding. Therefore, the thermal resistance between the bonding wires 6 and the at least one of the first part 1 and the second part 2 is low so that the bonding wires 6 help cooling the at least one of the first part 1 and the second part 2. As the bonding wire structure with the at least one bonding wire 6 is disposed inside the cavity 13, a cooling fluid 300 inside the cavity 13 physically contacts the at least one bonding wire 6 so that heat from the at least one bonding wire 6 is dissipated to the cooling fluid 300. If the cooler 10 has an inlet 11 and an outlet 12 and the cooling fluid 300 is pumped through the inlet opening 110 into the cavity 13, the cooling fluid 300 is locally heated by the at least one bonding wire 6. Subsequently, the heated cooling fluid 300 is discharged from the cavity 13 through the outlet opening 120. Alternatively to a cooler 10 having an inlet 11 and an outlet 12, the cooler 10 may be a closed system with the cooling fluid 300 filled in the cavity 13. Turbulences occurring in the cooling fluid 300 due to the bonding wire structure improve the heat exchange between the cooler 10 and the cooling fluid 300.

All of the bonding wires 6 of the bonding wire structure includes at least 99.50 percent by weight aluminium (Al), at least 0.25 percent by weight silicon (Si), at least 0.05 percent by magnesium (Mg) and at least 0.05 percent by weight manganese (Mn). Optionally, each of one, some or all of the bonding wires 6 of the bonding wire structure may be made of a precipitation hardening alloy. Examples for suitable precipitation hardening alloys are AlMgSi, AlMnSi, AlMgMnSi.

Compared to a conventional bonding wire consisting of aluminium only, the bonding wires 6 have, due to the included magnesium (Mg) and/or manganese (Mn), an increased corrosion resistance. However, magnesium and/or manganese as alloying constituent(s) of the aluminium-based bonding wires 6 also increase, again compared to a conventional bonding wire consisting of aluminium only, the stiffness of the bonding wires which in turn would adversely affect the ultrasonic-bondability of the bonding wires and, therefore, the long-time stability of the bond connection. In order to at least partially compensate for such an increased stiffness and the related worsened ultrasonic-bondability, silicon is added because silicon increases the cold formability and therefore both the ultrasonic bondability of the bonding wires 6 and the long-time stability of the bond connection, so that the tendency of bonding wire to lift offs is reduced. Furthermore, due to silicon Si as alloying constituent, the hardness and cold formability of the bonding wire can, prior to the ultrasonic bonding process, be adjusted by annealing steps in order to optimize the hardness and cold formability for the subsequent ultrasonic bonding process.

The power semiconductor module 100 includes a semiconductor chip 4 attached to the base plate 2. Optionally, a circuit board 3 may be disposed between the semiconductor chip 4 and the base plate 2. The semiconductor chip 4 has a semiconductor body 40, a first chip metallisation 41 and a second chip metallisation 42 both disposed on the semiconductor body 40. The semiconductor body 40 includes a monocrystalline or substantially monocrystalline semiconductor material, e.g., silicon, silicon carbide, gallium nitride, or any other semiconductor materials that can be used for semiconductor devices. The semiconductor body 40 may have one or more semiconductor regions doped with electrically active dopants, i.e. with dopants causing the respective semiconductor region to be n-doped or p-doped.

Optionally, the first and second chip metallisations 41, 42 may be disposed on opposite surfaces of the semiconductor body 40. For example, the first chip metallization 41 may be disposed on a first surface of the semiconductor body 40 facing away from the base plate 2 (and from the substrate 3, if provided), and the second chip metallization 42 may be disposed on a second surface of the semiconductor body 40 facing towards the base plate 2 (and towards the substrate 3, if provided). Alternatively, both the first and second chip metallisations 41, 42 may be disposed on the same surface of the semiconductor body 40. For example, the surface of the semiconductor body 40 may be the surface facing away from the base plate 2 (and from the circuit board 3, if provided). The semiconductor chip 4 may already be packaged prior to being attached to the base plate 2 (and prior to being attached to the circuit board 3, if provided), or, alternatively, be attached to the base plate 2 (and to the circuit board 3, if provided) as a bare semiconductor chip 4.

The semiconductor chip 4 may include a semiconductor component that has a load path formed between the first and second chip metallisations 41 and 42. The semiconductor component may be, for instance, a diode, or a controllable semiconductor component like a unipolar or bipolar transistor or a thyristor. In case of a transistor, the controllable semiconductor component may be, for instance, an IGFET (Insulated Gate Bipolar Transistor) like a MOSFET (Metal Oxide Semiconductor Field-Effect Transistor) or an IGBT (Insulated Gate Bipolar Transistor), a JFET (Junction Field Effect Transistor), a HEMT (High Electron Mobility Transistor), or any other transistor.

The first chip metallisation 41 and the second chip metallisation 42 may be a source metallisation and a drain metallisation, or a drain metallisation and a source metallisation, or an emitter metallisation and a collector metallisation, or collector metallisation and an emitter metallisation, or an anode metallisation and a cathode metallisation, or a cathode metallisation and an anode metallisation. The semiconductor component may optionally be a vertical semiconductor component with the first chip metallisation 41 and the second chip metallisation 42 disposed on opposite surfaces of the semiconductor body 40.

In case of a controllable semiconductor component, the semiconductor chip 4 has a third chip metallisation (not shown) that is disposed either on a first surface of the semiconductor body 40 facing away from the base plate 2 (and away from the circuit board 3, if provided), or on a second surface of the semiconductor body 40 facing toward the base plate 2 (and toward the circuit board 3, if provided). The third chip metallisation may be, for instance, a gate metallisation or a base metallisation.

Using one or more semiconductor chips 4 as described above, the semiconductor module 100 may include, for instance, a controllable semiconductor switch, a half-bridge, two half-bridges (e.g. a H-bridge), three half-bridges, multilevel circuits, or any other configuration. In a half-bridge, the load paths of two semiconductor chips 4 are electrically connected in series.

The semiconductor chip 4 is attached to the circuit board 3 using a first connection layer 81. The first connection layer 81 directly adjoins both the semiconductor chip 4 and the circuit board 3 and continuously extends there between. The first connection layer 81 may be solid (at 20°C). In order to electrically connect the semiconductor chip 4 at its second chip metallisation 42 with the circuit board 3, the first connection layer 81 may be electrically conductive and directly adjoin the second chip metallisation 42. A conductive first connection layer 81 may be, for example, a solder layer, a layer of a sintered metal powder (e.g. a silver powder), or a layer of an electrically conductive adhesive. If there is no requirement of electrically conductively connecting the semiconductor chip 4 at its second chip metallisation 42 with the circuit board 3, a dielectric first connection layer 81, for example a layer of a dielectric adhesive, may be used as well.

The circuit board 3 includes a dielectric insulation carrier 30, and a first circuit board metallisation layer 31 attached to the insulation carrier 30. The semiconductor chip 4 is attached to the first circuit board metallisation layer 31 so that the first circuit board metallisation layer 31 is disposed between the semiconductor chip 4 and the insulation carrier 30. Optionally, the circuit board 3 may include a second circuit board metallisation layer 32 that is attached to the insulation carrier 30 so that the dielectric insulation carrier 30 is disposed between the first circuit board metallisation layer 31 and the second circuit board metallisation layer 32. Each of the first circuit board metallisation layer 31 and, if provided, the second circuit board metallisation layer 32, may consist of or include one of the following materials: copper; a copper alloy; aluminium; an aluminium alloy; or any other metal or alloy having a good electrical conductivity.

The dielectric insulation carrier 30 may be a ceramic, for instance a thin ceramic layer. The ceramic may be, for example, composed of or include one of the following materials: aluminium oxide (Al₂O₃); aluminium nitride (AlN); zirconium oxide (ZrO₂); silicon nitride; boron nitride; or any other dielectric ceramic. The circuit board 3 may be, e.g., a DCB substrate (DCB=Direct Copper Bonding), a DAB substrate (DAB=Direct Aluminium Bonding), or an AMB substrate (AMB=Active Metal Brazing). In other examples, the dielectric insulation carrier 30 may be a solid, non-ceramic dielectric.

In the power semiconductor module arrangement 200 of Figure 2, the circuit board 3 is disposed between the semiconductor chip 4 and the cooler 10, and the first circuit board metallisation layer 31 is disposed between the dielectric layer 30 and the semiconductor chip 4. If the circuit board 3 also includes a second circuit board metallisation layer 32, the dielectric insulation carrier 30 is disposed between the first circuit board metallisation layer 31 and the second circuit board metallisation layer 32, and the second circuit board metallisation layer 32 is disposed between the dielectric circuit carrier 30 and the cooler 10. Independently of whether or not the circuit board 3 includes a second circuit board metallisation layer 32, the semiconductor chip 4 may be galvanically insulated from the second part 2 by the insulation carrier 30.

The semiconductor module 100 may include a bonding wire 5 that is, at a first bonding location 51, directly wire bonded to the first chip metallisation 41, and at a second bonding location 52, directly wire bonded to an arbitrary other element of the semiconductor module 100 in order to electrically connect the other element to the first chip metallisation 41. However, this is only an example. The electric interconnection of the (at least one) semiconductor chip 4 may be adapted to fulfil the requirements of the application to be realized.

Optionally, the power semiconductor module 100 may have a module housing 7 that may be configured in any desired fashion. In one example, the module housing 7 may consist of or include an electrically insulating material, for example plastic, e.g. a thermoplastic or thermoset. The module housing 7 may be embodied in an integral fashion, or else be assembled of two or more housing parts 71, 72. For instance, a module housing 7 may have a ring-shaped frame 71 having side walls, and, optionally, a lid 72. The lid 72 and the ring-shaped frame 71 may be formed in an integral fashion, or else be separate parts. The (at least one) semiconductor chip 4 is disposed inside the module housing 7. Optionally, the semiconductor chip 4 may be covered by a dielectric encapsulation 70, e.g. a gel, for example a silicone gel, so that the semiconductor chip 4 is disposed between the dielectric encapsulation 70 and the circuit board 3. The encapsulation 70 may be applied to the circuit board 3 and the semiconductor chip 4 subsequent to attaching the semiconductor chip 4 to the circuit board 3 by means of the first connection layer 81. In cases where the semiconductor chip 4 is a bare semiconductor chip 4, the encapsulation 70 may be in physical contact with the semiconductor body 40 of the semiconductor chip 4. Independently of whether or not the encapsulation 70 is in physical contact with the semiconductor body 40 of the semiconductor chip 4, the encapsulation 70 may be in physical contact with at least one of the insulation carrier 30 and the first circuit board metallisation layer 31. If the semiconductor module 100 has both a module housing 7 and an encapsulation 70, the encapsulation 70 may be disposed inside the module housing 7.

In order to allow for electrically contacting the power semiconductor module 100, it may have at least one electrical terminal 16 such as a sheet metal or a metal pin. The electrical terminal 16 is electrically connected to an electrical circuit that is disposed on the circuit board 3 and that includes the semiconductor chip 4. Further, the electrical terminal 16 is at least partially exposed so that it is accessible for electrically connecting it to a power supply or an electrical load that is external to the semiconductor module 100.

The circuit board 3 is attached to the base plate 2 using a second connection layer 82. The second connection layer 82 may be solid (at 20°C). The second connection layer 82 directly adjoins both the circuit board 3 and the base plate 2 and continuously extends there between. A second connection layer 82 may be, for example, a solder layer, a layer of a sintered metal powder, or a layer of an electrically conductive or a dielectric adhesive.

The base plate 2 has a thickness d2, the first circuit board metallisation layer 31 has a thickness d31, the second circuit board metallisation layer 32 has a thickness d32, and the insulation carrier 30 has a thickness d30. The thicknesses d2, d30, d31 and d32 are, in each case, to be measured in a direction perpendicularly (the z-direction in the depicted coordinate system x, y, z) to that surface 2t of the base plate 2 on which the semiconductor chip 4 is disposed, and can be combined in arbitrary manner. For instance, the thickness d2 may be at least 2.5 mm, or at least 3.0 mm. Optionally, d2 may be less than or equal to 5 mm. For instance, d2 may be at least 2.5 mm, or at least 3.0 mm. Using a base plate 2 having a thickness d2 of at least 2.5 mm provides for an improved resistance of the power semiconductor module 100 against the pressure the cooling fluid 300 exerts on the power semiconductor module 100. This pressure may be, for instance, in a range from 1.0 to 5 bar Pa absolute. Using such a thick base plate 2, with or without a circuit carrier 3 disposed between the semiconductor chip 4 and the base plate 2, the heat spreading effect is, compared to the heat spreading effect of just a circuit carrier 3 without a base plate 3, improved. The thickness d30 may be, for instance, in a range from 0.25 to 0.70 mm in order to provide for a low thermal resistance. In order to achieve an increased electrical insulation caused by the insulation carrier 30, d30 may be at least 1 mm. The thickness d31 may be in a range from 0.2 mm to 0.6 mm in order to provide for a high ampacity and a good mechanical stability of the circuit carrier 3. The thickness d32 may be in a range from 0.2 mm to 0.6 mm in order to provide for a good mechanical stability of the circuit carrier 3. Optionally, particularly when the first circuit board metallisation layer 31 and the second circuit board metallisation layer 32 are made of the same material or the same material composition, the thicknesses d31 and d32 may be equal in order to prevent the circuit carrier 3 from bending caused by significant different coefficients of thermal expansion of the insulation carrier 30 in the one hand and the first and second circuit board metallisation layers 31, 32 on the other hand.

A first part 1 and a base plate / second part 2 may consist of or include, independently from one another, for instance, at least one of the following materials: aluminium (Al); copper (Cu); aluminium-copper (AlCu); a metal-matrix-composit (MMC) material, e.g. aluminium silicon carbide (AlSiC), or any other MMC material. Optionally, the first part 1 may be made of metal. Also optionally, the second part / base plate 2 may be made of metal.

In order to improve the solderability of the surface 2t, for instance if a circuit carrier 3 is soldered to the surface 2t using the second connection layer 82 (which then is a solder layer), or if a semiconductor chip 4 without a circuit carrier 3 being disposed between the semiconductor chip 4 and the base plate 2 is soldered to the surface 2t using the first connection layer 81 (which then is a solder layer), the base plate 2 may have a coating which forms, at least in regions where the connection layer 82, 81 adjoins the base plate 2, the surface 2t. A suitable material for such a coating is, for example, nickel (Ni).

Similarly, in order to improve the sinterability of the surface 2t, for instance if a circuit carrier 3 is joined to the surface 2t by a sintered joint using the second connection layer 82 (which then is a layer of sintered metal powder), or if a semiconductor chip 4 without a circuit carrier 3 being disposed between the semiconductor chip 4 and the base plate 2 is joined to the surface 2t by a sintered joint using the first connection layer 81 (which then is a layer of sintered metal powder), the base plate 2 may have a coating which forms, at least in regions where the connection layer 82, 81 adjoins the base plate 2, the surface 2t. A suitable material for such a coating is, for example, a noble metal, e.g. silver (Ag), gold (Au), platinum (Pt).

Assembling the cooler 10 from two (or more) parts 1, 2 may facilitate the manufacturing of the cooler 10. For joining the first part 1 and the second part / base plate 2, an arbitrary suitable joining technique, for instance screwing, clipping, crimping, soldering, brazing, sintering, welding, may be used. The first part 1 and the second part 2 may be made of the same material, or of different materials, whereby the expression "material" is intended to not only include pure materials like a chemical element (e.g. copper, aluminium) but also homogeneous material compositions like an alloy, a ceramic, or a metal-matrix-composite material (e.g. aluminium silicon carbide).

The joint between the first part 1 and the second part / base plate 2 may be formed to be hermetically tight in order to prevent a cooling fluid inside the cavity 13 from flowing out of the cavity 13 through a gap 210 between the first part 1 and the second part 2. If the joining technique used for joining the first part 1 and the second part 2 causes a non-material-locking joint (e.g. screwing, clipping, crimping), a gasket 21 may be inserted between the first part 1 and the second part 2 in order to hermetically seal the gap 210 between the first part 1 and the second part 2. As a gasket 21, any type of gasket allowing for hermetically sealing the gap 210 may be used, for instance, an O-ring gasket, a flat gasket, or any other suitable type of gasket. Optionally, the gasket 21 may have the shape of a closed ring. Instead of one and only one gasket 21, two or more than two gaskets 21 may be used for hermetically sealing the gap 210 between the first part 1 and the second part 2.

A power semiconductor module arrangement 200 may be produced by joining the (at least one) semiconductor chip 4 with the base plate 2 using the first connection layer 81. To this, the semiconductor chip 4 may be joined with the circuit carrier 3 using the first connection layer 81, and, subsequently, the circuit carrier 3 may be joined with the base plate 2 using the second connection layer 82. Alternatively, the circuit carrier 3 may be joined with the base plate 2 using the second connection layer 82 first, and, subsequently, the semiconductor chip 4 may be joined with the circuit carrier 3 using the first connection layer 81. If there is no circuit carrier 3 to be disposed between the semiconductor chip 4 and the base plate 2, the semiconductor chip 4 may be joined with the base plate 2 using the first connection layer 81 so that the first connection layer 81 continuously extends between the base plate 2 and the semiconductor chip 4.

All bonding wires 6 forming the bonding wire structure are directly joined to a first surface s1 of the cooler body which includes both the first part 1 and the base plate / second part 2. That is, each of the bonding wires 6 is in physical contact with the first surface s1 which in the example of Figures 1 and 2 is a surface 2b of the second part / base plate 2 opposite a surface 2t of the second part / base plate 2 on which the semiconductor chip 4 is disposed.

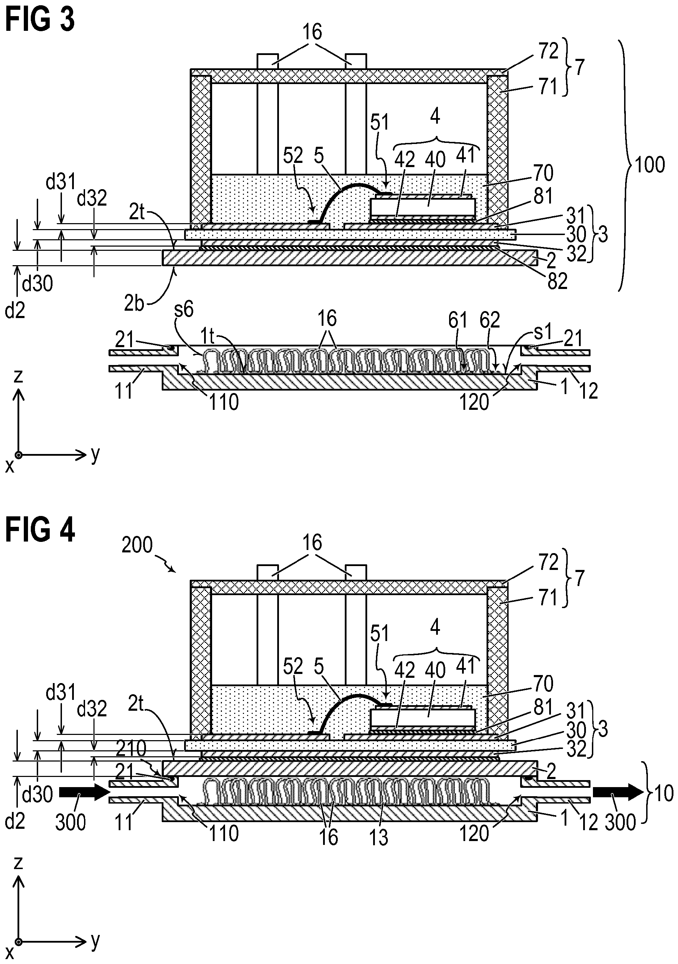

In a further example illustrated in Figures 3 and 4, the first surface s1, to which the bonding wires 6 are bonded, is a surface of the first part 1.

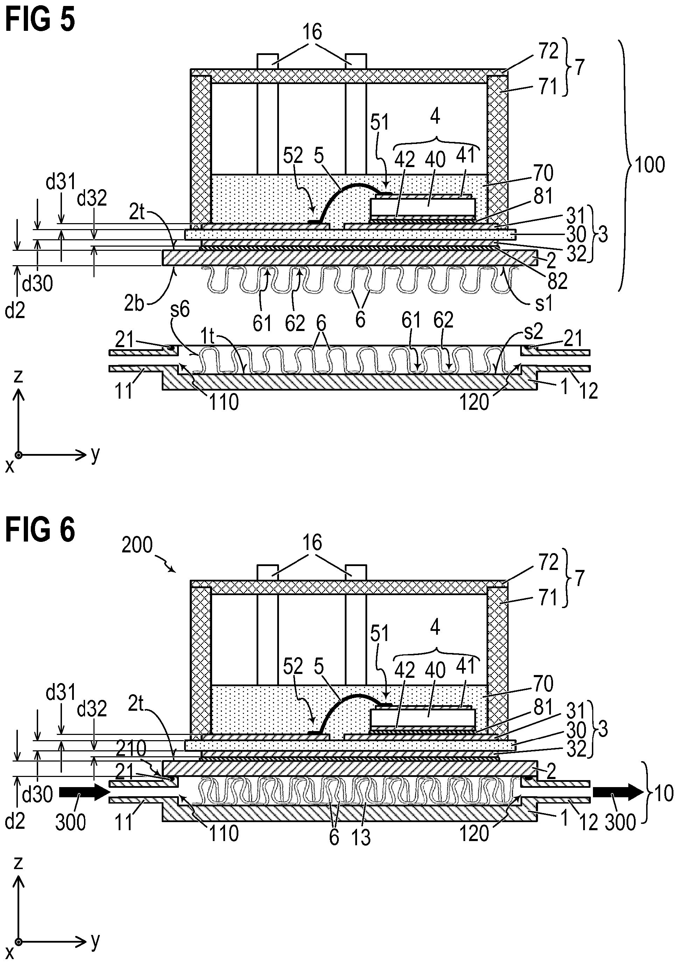

Still a further example is illustrated in Figures 5 and 6, wherein at least one or some of the bonding wires 6 of the bonding wire structure are directly bonded to a first surface s1 which is a surface 2b of the base plate / second part 2 opposite the surface 2t on which the semiconductor chip 4 is disposed, and wherein at least one or some of the bonding wires 6 of the bonding wire structure are directly bonded to a second surface s2 which is a surface of the first part 1.

Apart from the different properties of the bonding wire structures, the properties of the power semiconductor modules 100 and the power semiconductor module arrangements 200 and the methods of producing the power semiconductor modules 100 and the power semiconductor module arrangements 200 of Figures 3 to 6 may be the same as described with reference to Figures 1 and 2. The properties of the bonding wires 6 and the method for joining the bonding wires 6 by ultrasonic wire bonding to the first surface s1 explained with reference to Figures 1 and 2 also apply for the bonding wires 6 and the method for joining the bonding wires 6 by ultrasonic wire bonding to the respective first or second surface s1, s2 described with reference to Figures 3 to 6.

As far as bonding wires 6 are bonded to a first surface 1s (2b) of a base plate 2 for a power semiconductor module 100 by ultrasonic wire bonding, the respective ultrasonic wire bonding process may take place at any stage of the production process of the power semiconductor module 100. For instance, the bonding wires 6 may be bonded to the surface 2b of the bare base plate 2, and subsequently the circuit carrier 3 may be joined to the surface 2t of the base plate 2 using the second connection layer 82. Thereby, joining the semiconductor chip 4 to the circuit carrier 3 using the first connection layer 81 may take place prior to or after joining the circuit carrier 3 to the surface 2t of the base plate 2. If there is no circuit carrier 3 to be disposed between the semiconductor chip 4 and the base plate 2, the semiconductor chip 4 may be joined to the surface 2t of the base plate 2 using the first connection layer 81 prior to or after bonding the bonding wires 6 to the surface 2b.

In a further example (not illustrated), a cooler 10 that includes a first part 1, a second part 2 and a bonding wire structure with at least one bonding wire 6 bonded to at least one of the first and second part 1, 2 as described with reference to Figures 1 to 6 but without any components mounted to the surface 2t may be produced in the same manner. Such a cooler 10 may be used as a cooler for arbitrary applications, for instance as a cooler for a power semiconductor module that has, apart from the base plate 2 and the second connection layer 82, the properties of the power semiconductor module 100 described with reference to Figures 1 and 2.

If a surface material of a bonding wire 6 differs from a surface material of at least one of the first part 1 and the second part 2, electrochemical degradation of the bonding wire 6 or the first or second part 1, 2 may occur. Such a degradation may cause the bonding wire 6 to lift off from the surface s1 or s2 to which it is bonded and lead to a deterioration of the thermal contact between the bonding wire structure a and the respective surface s1, s2. In order to prevent or at least delay such a degradation, the electrochemical standard potentials of a surface material forming a surface s6 of the bonding wire and of a surface material forming the first or second surface s1, s2, to which the bonding wire 6 is bonded, may be chosen such that they do not differ too much. For instance, the surface s1, s2, to which the bonding wire 6 is bonded, may be formed by a first surface material having, at a temperature of 25°C and a pressure of 101.3 kPa, a first standard potential, the surface s6 of the bonding wire 6 may be formed by a second surface material having, at a temperature of 25°C and a pressure of 101.3 kPa, a second standard potential, and the absolute value of the difference between the first standard potential and the second standard potential may be less than 1.50 V. However, an absolute value equal to or greater than 1.50 V causing an increased degradation may also be accepted. The absolute value may be 0.0 V, or be greater than 0.0 V.

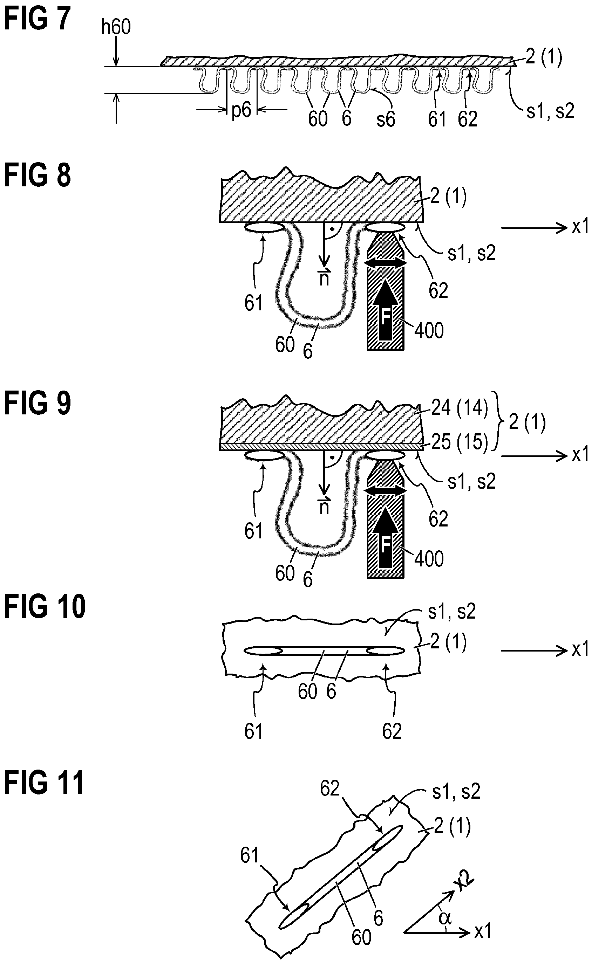

Figure 7 illustrates a bonding wire 6 that is directly bonded, at a plurality of bonding locations 61, 62, to a first surface s1 or a second surface s2 of a first part 1 or a second part / base plate 2. The first surface s1 may be a surface of the second part / base plate 2 as explained with reference to Figures 1 and 2, or a surface of the first part 1 as explained with reference to Figures 3 and 4. If there is at least one bonding wire 6 bonded to the second part / base plate 2 and at least one further bonding wire 6 bonded to the first part 1 as explained with reference to Figures 5 and 6, the first surface s1 is a surface of the second part / base plate 2 and the second surface s2 is a surface of the first part 1.

Between adjacent bonding locations 61, 62, the bonding wire 6 forms a bonding wire loop 60 having, relative to the first or second surface s1, s2, a loop height h60. The loop height h60 of a bonding wire loop 60 is the maximum distance a surface of the bonding wire loop 60 has from the surface s1, s2, to which the adjacent bonding locations 61, 62 are bonded to. The loop heights h60 of one, some or all bonding wire loops 60 of the bonding wire structure may be, for instance, in a range from 1 mm to 4 mm. Further, the adjacent bonding locations 61, 62 of a bonding wire 6 may have a pitch p6, i.e. a repeat distance the adjacent bonding locations 61 and 62 have. The repeat distance p6 of one, some or all pairs of adjacent bonding locations 61, 62 of the same bonding wire 6 of the bonding wire structure may be, for instance, in a range from 1 mm to 4 mm.

As explained above, each of the bonding wires 6 of the bonding wire structure is, at at least one bonding location 61, 62, directly bonded to the first part 1 or the second part 2, i.e. to the first surface s1 or the second surface s2, by ultrasonic wire bonding. Figure 8 exemplarily illustrates for a second bonding location 62, when the bonding wire 6 is ultrasonic wire bonded at the second bonding location 62 to the first surface s1 or the second surface s2. To this, a wire bonder 400 presses the bonding wire 6 at the second bonding location 62 with a contact pressing force F against the first surface s1 or the second surface s2, and, simultaneously, vibrates at a ultrasonic frequency substantially parallel the respective surface s1, s2 as schematically illustrated by a double-headed arrow. The ultrasonic frequency may be, for instance, in a range from 20 kHz to 300 kHz. The contact pressing force F may be, for instance, at least 2 to 4 kN (Kilo-Newton). Due to the combined impact of both the contact pressing force F and the ultrasonic vibration, a tight bond is formed at the second bonding location 62 between the bonding wire 6 and the respective surface s1, s2. In the same way, the same or a different bonding wire 6 may be joined to a first surface 1 or a second surface 2 at each other bonding location.

As illustrated in Figure 9, the first part 1 may optionally include a first core 14 and a first surface coating 15 applied to the first core 14, and the second part / base plate 2 may, also optionally, include a second core 24 and a second surface coating 25 applied to the second core 24. Such a coating 15, 25 may improve the bondability and/or provide for a low absolute value of the difference between the first standard potential and the second standard potential as explained above. Suitable materials for such coatings 15, 25 are, for example, nickel (Ni), zinc (Zn), tin (Sn), titanium (Ti), chromium (Cr) or aluminium (Al). The thickness of such a coating 15 and/or 25 may be, in each case, in a range from 2 µm to 12 µm in order to reliably resist the subsequent ultrasonic bonding process. However, coatings 15 and/or 25 having thicknesses greater than 12 µm are also acceptable. A coating 15 and/or 25 may be produced by galvanising the respective core 14, 24. Alternatively, a coating 15 and/or 25 of the respective core 14, 24 may be provided as a pre-fabricated metal plate and joined to the respective core 14, 24 and then rolled with one another. For this purpose, the pre-fabricated metal plate and the respective core 14, 24 are placed against one another in a manner overlapping one another and are rolled with one another, for example between two rollers. After rolling, the metal plate and the respective core 14, 24 form a composite. Optionally, the composite may be heated in an annealing process to temperatures of at least 250°C. After the rolling and, if applicable, after the annealing process, the respective coating 15, 25 may have a thickness of at least 0.2 mm.

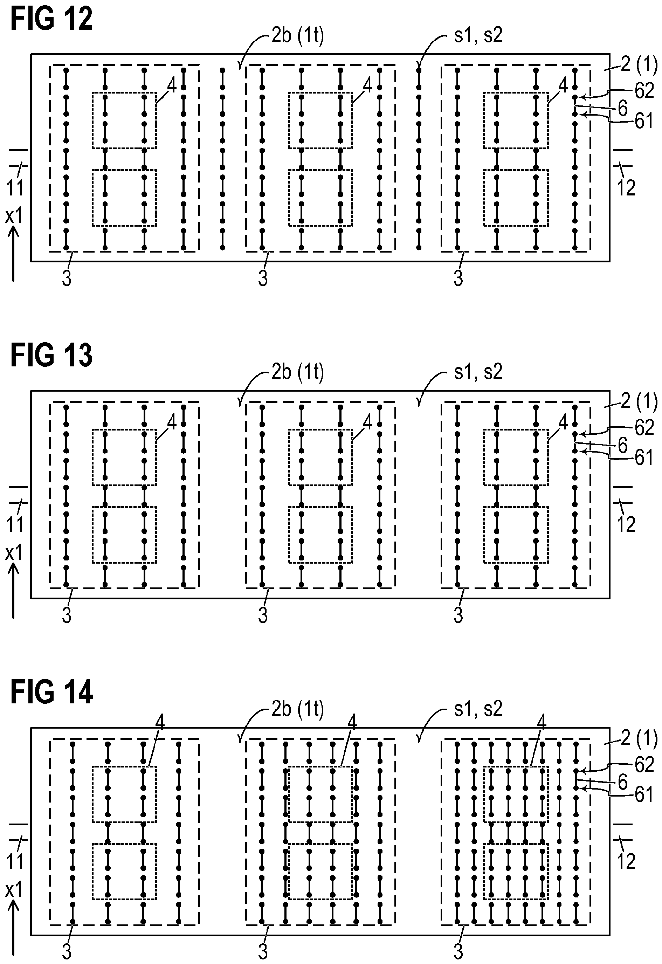

Figure 10 illustrates a bonding wire 6 as explained with reference to Figures 8 or 9 that is bonded to the same surface s1, s2 at two adjacent bonding locations 61 and 62 with a bonding wire loop 60 formed in between. The adjacent bonding locations 61 and 62 are disposed distant from one another in a first lateral direction x1, wherein a lateral direction is a direction perpendicular to a normal vector n of the respective surface s1, s2. Similarly, Figure 11 illustrates a further bonding wire 6 that is, analogously to the bonding wire 6 explained with reference to Figures 8 or 9, at two adjacent bonding locations 61 and 62 bonded to the same surface s1, s2 as the bonding wire 6, with a bonding wire loop 60 formed between the adjacent bonding locations 61 and 62. The adjacent bonding locations 61 and 62 are disposed distant from one another in a second lateral direction x2 different from the first lateral direction x1 explained with reference to Figure 10. The first lateral direction x1 and the second lateral direction x2 include an angle α > 0°. For instance, the angle α may be at least 15° and less than or equal to 90°. Due to their different spatial orientations, the bonding wire loops 60 of the bonding wire 6 and the bonding wire loops 60 of the further bonding wire 6 cause significantly different flow resistances with respect to the cooling fluid 300. Further, the areal density of the bonding wire loops 60 of the bonding wire structure has also an influence on the flow resistance. Therefore, the spatial orientation and the areal density of the bonding wire loops 60 may be used for guiding the flow distribution of the cooling fluid 300 inside the cavity 13. Figures 12 to 15 illustrate different examples how that effect may be used.

Each of Figures 12 to 15 is a view on a first or second surface s1, s2 which may be a surface of the first part 1 or the second part / base plate 2 as explained above. Dashed lines illustrate the positions (contours) of three circuit carriers 3 joined with the base plate 2, and dotted lines illustrate the positions (contours) of semiconductor chips 4 joined with the circuit carriers 3. Also schematically illustrated are the positions of the inlet 11 and the outlet 12 so that the direction of the flow of the cooling fluid 300 is from left to right.

In each of the examples of Figures 12, 13 and 14, the adjacent bonding locations 61 and 62 of each of the bonding wire loops 60 of the bonding structure are disposed distant from one another in the same (first) lateral direction x1. In the example of Figure 12, the bonding wire loops 60 of the bonding structure are evenly distributed over the first or second surface s1, s2. In the examples of Figures 13 and 14, the bonding wire loops 60 of the bonding structure are only disposed in circuit carrier regions correlated with the footprints of the circuit carriers 3. However, outside these circuit carrier regions, there is no bonding wire 6 bonded to the respective first or second surface s1, s2 so that the pressure drop of the cooling fluid 300 caused by the bonding wire structure can be kept low. In the example of Figure 13, the distribution of the bonding wire loops 60 is identical throughout the different circuit carrier (footprint) regions, whereas the areal density the bonding wire loops 60 of Figure 14 have within the individual circuit carrier (footprint) regions increases, in the direction from the input 11 to the output 12 (i.e. the average flow direction of the cooling fluid 300), from circuit carrier region to circuit carrier region. Such an increasing areal density may be used in order to compensate for the effect that the cooling fluid 300 is significantly pre-heated by one or some preceding circuit carrier regions. Such effects often occur in connection with power semiconductor module arrangements 200 in which the base plate 2 has, in a direction from the inlet 11 to the outlet 12, a length of at least 15 cm.

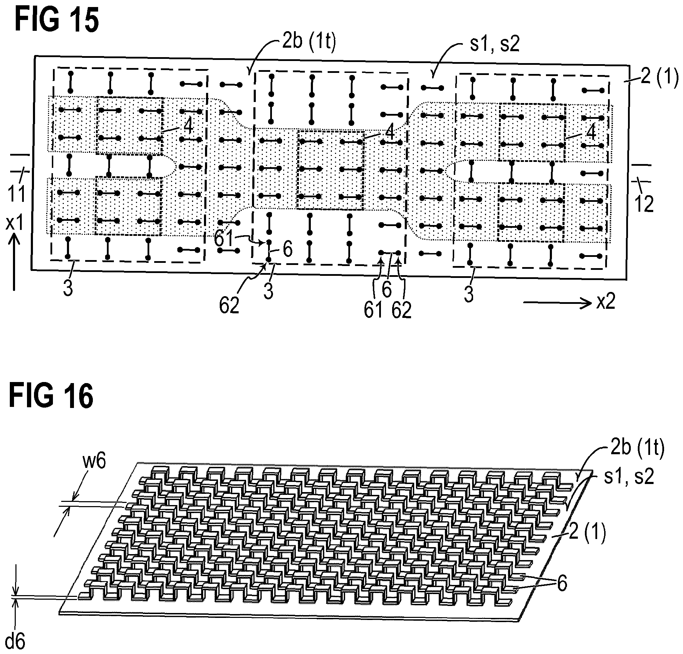

In the example of Figure 15, the adjacent bonding locations 61 and 62 of a first subset of the bonding wire loops 60 of the bonding structure are disposed distant from one another in the same (first) lateral direction x1 which is different from the average flow direction of the cooling fluid 300 (i.e. the direction from the input 11 to the output 12) so that the bonding wire loops 60 of the first subset cause a high flow resistance. In contrast, the adjacent bonding locations 61 and 62 of a second subset of the bonding wire loops 60 of the bonding structure are disposed distant from one another in the same (second) lateral direction x2 which is different from the first lateral direction x1 as described above in more detail with reference to Figure 11 and which is identical or substantially identical to the average flow direction so that the bonding wire loops of the second subset of bonding wire loops 60 cause a low flow resistance. Therefore, the flow speed of the cooling fluid 300 tends to be lower in the regions of the bonding wire loops 60 of the first subset than in the regions of the bonding wire loops 60 of the second subset. By applying this principle, the guidance of the cooling fluid 300 may be designed such that the cooling fluid 300 has, in chip regions correlated with the footprints of the semiconductor chips 4, a higher flow speed than outside these chip regions so that the heat emitted by the semiconductor chips 4 is quickly removed by the cooling fluid 300. In Figure 15, the regions in which the cooling fluid 300 has high flow speeds are illustrated in shaded fashion. In the example of Figure 15, the first lateral direction x1 and the second lateral direction x2 run perpendicularly. That is, the angle α (see Figure 11) is 90°. However, angles α of less than 90° may be used as well.

In connection with the present invention, any type of bonding wires 6 may be used. In one example, one, some or all of the bonding wires 6 of the bonding wire structure may have, outside of bonding locations 61, 62, a circular cross-section. Such a bonding wire 6 may have, outside of bonding locations 61, 62, for instance a diameter from 0.1 mm to 1 mm. Alternatively or additionally, one, some or all of the bonding wires 6 of the bonding wire structure may have, outside of bonding locations 61, 62, a rectangular or substantially rectangular cross-section (such bonding wires 6 are also referred to as "ribbons"). An example for a bonding wire structure having at least one ribbon-shaped bonding wire 6 bonded to a first or second surface s1, s2 is illustrated in Figure 16. Such a ribbon-shaped bonding wire 6 may have, for instance, a thickness d6 from 200 µm to 400 µm, and a width w6 of 2 mm to 4 mm.

Optionally, the bonding wires 6 of a bonding wire structure may be galvanically insulated from the semiconductor chip 4, and/or have no electrical function.

## Claims

1. A cooler (10) for a power semiconductor module arrangement comprising a cooler body (1, 2), a cavity (13) formed in the cooler body (1, 2), and a bonding wire (6) disposed inside the cavity (13) and directly bonded to a first surface (2b, 1t) of the cooler body (1, 2), **characterized in that** the bonding wire (6) comprises
at least 99.50 percent by weight aluminium (Al);
at least 0.25 percent by weight silicon (Si);
at least 0.05 percent by weight magnesium (Mg); and
at least 0.05 percent by weight manganese (Mn).

2. The cooler of claim 1, wherein
the cooler body (1, 2) comprises a first part (1) and a second part (2) joined to the first part (1); and
the first surface (1t) is a surface of the first part (1).

3. The cooler of claim 1, wherein
the cooler body (1, 2) comprises a first part (1) and a second part (2) joined to the first part (1); and
the first surface (2b) is a surface of the second part (2).

4. The cooler of claim 2 or 3, wherein the second part (2) comprises a thickness (d2) of at least 2.5 mm.

5. The cooler of any of the preceding claims, wherein the bonding wire (6) is, at at least two bonding locations (61, 62), directly bonded to the first surface (2b, 1t).

6. The cooler of any of the preceding claims, wherein
the first surface (2b, 1t) is formed by a first surface material having, at a temperature of 25°C and a pressure of 101.3 kPa, a first standard potential;
the bonding wire (6) comprises a second surface (s6) that is formed by a second surface material having, at a temperature of 25°C and a pressure of 101.3 kPa, a second standard potential; and
the absolute value of the difference between the first standard potential and the second standard potential is less than 1.50 V.

7. The cooler of any of the preceding claims, comprising
an inlet opening (110) for supplying a cooling fluid (300) to the cavity (13); and
an outlet opening (120) for discharging a cooling fluid (300) from the cavity (13).

8. A power semiconductor module arrangement comprising
a cooler (10) of any of the preceding claims; and
a semiconductor chip (4) attached to a contact surface (2t) of the cooler (10).

9. The power semiconductor module arrangement of claim 8, comprising:
a circuit board (3) comprising a first circuit board metallisation layer (31), a second circuit board metallisation layer (32) and a dielectric insulation carrier (30) disposed between the first circuit board metallisation layer (31) and the second circuit board metallisation layer (32), wherein
the circuit board (3) is disposed between the semiconductor chip (4) and the cooler (10);
the first circuit board metallisation layer (31) is disposed between the dielectric insulation carrier (30) and the semiconductor chip (4); and
the second circuit board metallisation layer (32) is disposed between the dielectric insulation carrier (30) and the cooler (10).

10. The power semiconductor module arrangement of claim 8 or 9, wherein the semiconductor chip (4) is galvanically insulated from the second part (2).

11. The power semiconductor module arrangement of any of claims 8 to 10 comprising a circuit board (3) and a dielectric encapsulation (70), wherein the semiconductor chip (4) is disposed between the circuit board (3) and the dielectric encapsulation (70).

12. A method for producing a cooler for a a power semiconductor module arrangement, the method comprising:
directly bonding a bonding wire (6) to a first surface (2b, 1t) of a first part (1) or of a second part (2) of the cooler body (1, 2) by ultrasonic wire bonding;
joining the first part (1) and the second part (2) so that a cavity (13) is formed between the first part (1) and the second part (2), and that the bonding wire (6) is disposed inside the cavity (13);
wherein the bonding wire (6) comprises
at least 99.5 percent by weight aluminium (Al);
at least 0.25 percent by weight silicon (Si);
at least 0.05 percent by weight magnesium (Mg); and
at least 0.05 percent by weight manganese (Mn).

13. A method for producing a cooler power semiconductor module arrangement, the method comprising:
producing a cooler according to the method claimed in claim 12; and
attaching a semiconductor chip (4) to the second part (2).

14. The method of claim 13, wherein attaching the semiconductor chip (4) to the second part (2) comprises:
attaching the semiconductor chip (4) to a first circuit board metallisation layer (31) of a circuit board (3) comprising the first circuit board metallisation layer (31), a second circuit board metallisation layer (32), and a dielectric insulation carrier (30) disposed between the first circuit board metallisation layer (31) and the second circuit board metallisation layer (32); and
attaching the second part (2) to the second circuit board metallisation layer (32) so that the circuit board (3) is disposed between the semiconductor chip (4) and the cooler (10).

## Patentansprüche

1. Kühler (10) für eine Leistungshalbleitermodulanordnung, umfassend einen Kühlerkörper (1, 2), einen Hohlraum (13), der in dem Kühlerkörper (1, 2) gebildet ist, und einen Bonddraht (6), der innerhalb des Hohlraums (13) angeordnet und direkt an eine erste Oberfläche (2b, 1t) des Kühlerkörpers (1, 2) gebondet ist, **dadurch gekennzeichnet, dass** der Bonddraht (6) umfasst:
mindestens 99,50 Gewichtsprozent Aluminium (Al);
mindestens 0,25 Gewichtsprozent Silicium (Si);
mindestens 0,05 Gewichtsprozent Magnesium (Mg);
mindestens 0,05 Gewichtsprozent Mangan (Mn).

2. Kühler nach Anspruch 1, wobei
der Kühlerkörper (1, 2) ein erstes Teil (1) und ein zweites Teil (2) umfasst, das an das erste Teil (1) gefügt ist; und
die erste Oberfläche (1t) eine Oberfläche des ersten Teils (1) ist.

3. Kühler nach Anspruch 1, wobei
der Kühlerkörper (1, 2) ein erstes Teil (1) und ein zweites Teil (2) umfasst, das an das erste Teil (1) gefügt ist; und
die erste Oberfläche (2b) eine Oberfläche des zweiten Teils (2) ist.

4. Kühler nach Anspruch 2 oder 3, wobei das zweite Teil (2) eine Dicke (d2) von mindestens 2,5 mm umfasst.

5. Kühler nach einem der vorhergehenden Ansprüche, wobei der Bonddraht (6) an mindestens zwei Bonding-Positionen (61, 62) direkt an die erste Oberfläche (2b, 1t) gebondet ist.

6. Kühler nach einem der vorhergehenden Ansprüche, wobei
die erste Oberfläche (2b, 1t) durch ein erstes Oberflächenmaterial gebildet ist, das bei einer Temperatur von 25 °C und einem Druck von 101,3 kPa ein erstes Standardpotential hat;
der Bonddraht (6) eine zweite Oberfläche (s6) umfasst, die durch ein zweites Oberflächenmaterial gebildet ist, das bei einer Temperatur von 25 °C und einem Druck von 101,3 kPa ein zweites Standardpotential hat; und
der Absolutwert der Differenz zwischen dem ersten Standardpotential und dem zweiten Standardpotential weniger als 1,50 V beträgt.

7. Kühler nach einem der vorhergehenden Ansprüche, umfassend:
eine Einlassöffnung (110) zum Zuführen eines Kühlfluids (300) zu dem Hohlraum (13); und
eine Auslassöffnung (120) zum Austragen eines Kühlfluids (300) aus dem Hohlraum (13).

8. Leistungshalbleitermodulanordnung, umfassend:
einen Kühler (10) nach einem der vorhergehenden Ansprüche; und
einen Halbleiterchip (4), der an einer Kontaktoberfläche (2t) des Kühlers (10) befestigt ist.

9. Leistungshalbleitermodulanordnung nach Anspruch 8, umfassend:
eine Schaltplatine (3), umfassend eine erste Schaltplatinenmetallisierungsschicht (31), eine zweite Schaltplatinenmetallisierungsschicht (32) und einen dielektrischen Isolationsträger (30), der zwischen der ersten Schaltplatinenmetallisierungsschicht (31) und der zweiten Schaltplatinenmetallisierungsschicht (32) angeordnet ist, wobei
die Schaltplatine (3) zwischen dem Halbleiterchip (4) und dem Kühler (10) angeordnet ist;
die erste Schaltplatinenmetallisierungsschicht (31) zwischen dem dielektrischen Isolationsträger (30) und dem Halbleiterchip (4) angeordnet ist; und
die zweite Schaltplatinenmetallisierungsschicht (32) zwischen dem dielektrischen Isolationsträger (30) und dem Kühler (10) angeordnet ist.

10. Leistungshalbleitermodulanordnung nach Anspruch 8 oder 9, wobei der Halbleiterchip (4) galvanisch von dem zweiten Teil (2) isoliert ist.

11. Leistungshalbleitermodulanordnung nach einem der Ansprüche 8 bis 10, umfassend eine Schaltplatine (3) und eine dielektrische Verkapselung (70), wobei der Halbleiterchip (4) zwischen der Schaltplatine (3) und der dielektrischen Verkapselung (70) angeordnet ist.

12. Verfahren zum Fertigen eines Kühlers für eine Leistungshalbleitermodulanordnung, wobei das Verfahren umfasst:
direktes Bonden eines Bonddrahts (6) an eine erste Oberfläche (2b, 1t) eines ersten Teils (1) oder eines zweiten Teils (2) des Kühlerkörpers (1, 2) durch Ultraschalldrahtbonden;
Fügen des ersten Teils (1) und des zweiten Teils (2), so dass ein Hohlraum (13) zwischen dem ersten Teil (1) und dem zweiten Teil (2) gebildet wird, und dass der Bonddraht (6) innerhalb des Hohlraums (13) angeordnet ist;
wobei der Bonddraht (6) umfasst:
mindestens 99,5 Gewichtsprozent Aluminium (Al);
mindestens 0,25 Gewichtsprozent Silicium (Si);
mindestens 0,05 Gewichtsprozent Magnesium (Mg); und
mindestens 0,05 Gewichtsprozent Mangan (Mn).

13. Verfahren zum Fertigen einer Kühlerleistungshalbleitermodulanordnung, wobei das Verfahren umfasst:
Fertigen eines Kühlers gemäß dem Verfahren nach Anspruch 12; und
Befestigen eines Halbleiterchips (4) an dem zweiten Teil (2) .

14. Verfahren nach Anspruch 13, wobei Befestigen des Halbleiterchips (4) an dem zweiten Teil (2) umfasst:
Befestigen des Halbleiterchips (4) an einer ersten Schaltplatinenmetallisierungsschicht (31) einer Schaltplatine (3), umfassend die erste Schaltplatinenmetallisierungsschicht (31), eine zweite Schaltplatinenmetallisierungsschicht (32) und einen dielektrischen Isolationsträger (30), der zwischen der ersten Schaltplatinenmetallisierungsschicht (31) und der zweiten Schaltplatinenmetallisierungsschicht (32) angeordnet ist; und
Befestigen des zweiten Teils (2) der zweiten Schaltplatinenmetallisierungsschicht (32) so, dass die Schaltplatine (3) zwischen dem Halbleiterchip (4) und dem Kühler (10) angeordnet ist.

## Revendications

1. Refroidisseur (10) d'un agencement de module à semiconducteur de puissance comprenant un corps (1, 2) de refroidisseur, une cavité (13) formée dans le corps (1, 2) de refroidisseur, et un fil (6) de liaison, disposé à l'intérieur de la cavité (13) et relié directement à une première surface (2b, 1t) du corps (1, 2) de refroidisseur, **caractérisé en ce que** le fil (6) de liaison comprend
au moins 99,50 pourcent en poids d'aluminium (Al) ;
au moins 0,25 pourcent en poids de silicium (Si) ;
au moins 0,05 pourcent en poids de magnésium (Mg) ; et
au moins 0,05 pourcent en poids de manganèse (Mn).

2. Refroidisseur suivant la revendication 1, dans lequel
le corps (1, 2) de refroidisseur comprend une première partie (1) et une deuxième partie (2) réunie à la première partie (1) ; et
la première surface (1t) est une surface de la première partie (1).

3. Refroidisseur suivant la revendication 1, dans lequel
le corps (1, 2) de refroidisseur comprend une première partie (1) et une deuxième partie (2) réunie à la première partie (1) ; et
la première surface (2b) est une surface de la deuxième partie (2).

4. Refroidisseur suivant la revendication 2 ou 3, dans lequel la deuxième partie (2) comprend une épaisseur (d2) d'au moins 2,5 mm.

5. Refroidisseur suivant l'une quelconque des revendications précédentes, dans lequel le fil (6) de liaison est relié directement en au moins deux emplacements (61, 62) de liaison à la première surface (2b, 1t).

6. Refroidisseur suivant l'une quelconque des revendications précédentes, dans lequel
la première surface (2b, 1t) est formée par un premier matériau de surface, ayant un premier potentiel normal à une température de 25° C et sous une pression de 101,3 kPa ;
le fil (6) de liaison comprend une deuxième surface (s6), qui est formée d'un deuxième matériau de surface, ayant un deuxième potentiel normal à une température de 25° C et sous une pression de 101,3 kPa ; et
la valeur absolue de la différence entre la premier potentiel normal et le deuxième potentiel normal est inférieure à 1,50 V.

7. Refroidisseur suivant l'une quelconque des revendications précédentes, comprenant :
une ouverture (110) d'entrée pour envoyer du fluide (300) de refroidissement à la cavité (13) ; et
une ouverture (120) de sortie pour évacuer du fluide (300) de refroidissement de la cavité (13).

8. Agencement de module à semiconducteur de puissance comprenant
un refroidisseur (10) suivant l'une quelconque des revendications précédentes ; et
une puce (4) à semiconducteur fixée à une surface (2t) de contact du refroidisseur (10).

9. Agencement de module à semiconducteur de puissance suivant la revendication 8, comprenant :
une plaquette (3) à circuit imprimé comprenant une première couche (31) de métallisation de plaquette à circuit imprimé, une deuxième couche (32) de métallisation de plaquette à circuit imprimé, et un support (30) isolant diélectrique disposé entre la première couche (31) de métallisation de plaquette à circuit imprimé et la deuxième couche (32) de métallisation de plaquette à circuit imprimé, dans lequel
la plaquette (3) à circuit imprimé est disposée entre la puce (4) à semiconducteur et le refroidisseur (10) ;
la première couche (31) de métallisation de plaquette à circuit imprimé est disposée entre le support (30) isolant diélectrique et la puce (4) à semiconducteur ; et
la deuxième couche (32) de métallisation de plaquette à circuit imprimé est disposée entre le support (30) isolant diélectrique et le refroidisseur (10).

10. Agencement de module à semiconducteur de puissance suivant la revendication 8 ou 9, dans lequel la puce (4) à semiconducteur est isolée galvaniquement de la deuxième partie (2).

11. Agencement de module à semiconducteur de puissance suivant l'une quelconque des revendications 8 à 10, comprenant une plaquette (3) à circuit imprimé et une encapsulation (70) diélectrique, dans lequel la puce (4) à semiconducteur est disposée entre la plaquette (3) à circuit imprimé et l'encapsulation (70) diélectrique.

12. Procédé de fabrication d'un refroidisseur d'un agencement de module à semiconducteur de puissance, procédé dans lequel :
on relie directement un fil (6) de liaison à une première surface (2b, 1t) d'une première partie (1) ou d'une deuxième partie (2) du corps (1, 2) de refroidisseur par liaison par fil par ultrasons ;
on réunit la première partie (1) et la deuxième partie (2), de manière à former une cavité (13) entre la première partie (1) et la deuxième partie (2) et de manière à ce que le fil (6) de liaison soit disposé à l'intérieur de la cavité (13) ;
dans lequel le fil (6) de liaison comprend :
au moins 99,50 pourcent en poids d'aluminium (Al) ;
au moins 0,25 pourcent en poids de silicium (Si) ;
au moins 0,05 pourcent en poids de magnésium (Mg) ; et
au moins 0,05 pourcent en poids de manganèse (Mn).

13. Procédé de production d'un agencement de module à semiconducteur de puissance à refroidisseur, procédé dans lequel :
on produit un refroidisseur suivant le procédé suivant la revendication 12 ; et
on fixe une puce (4) à semiconducteur à la deuxième partie (2) .

14. Procédé suivant la revendication 13, dans lequel fixer la puce (4) à semiconducteur à la deuxième partie (2) comprend :
fixer la puce (4) à semiconducteur à une première couche (31) de métallisation d'une plaquette (3) à circuit imprimé comprenant la première couche (31) de métallisation de plaquette de circuit imprimé, une deuxième couche (32) de métallisation de plaquette à circuit imprimé et un support (30) isolant diélectrique disposé entre la première couche (31) de métallisation de plaquette à circuit imprimé et la deuxième couche (32) de métallisation de plaquette à circuit imprimé ; et
fixer la deuxième partie (2) à la deuxième couche (32) de métallisation de plaquette à circuit imprimé, de manière à ce que la plaquette (3) à circuit imprimé soit disposée entre la puce (4) à semiconducteur et le refroidisseur (10).
